# EUROPÄISCHE PATENTSCHRIFT

(11) **EP 2 167 705 B1**
(45) Veröffentlichungstag und Bekanntmachung des Hinweises auf die Patenterteilung: **17.09.2014**
(21) Anmeldenummer: 08750326.4
(22) Anmeldetag: 16.05.2008
(51) Int. Cl.: C23C 30/00, C23C 28/00, B22F 7/00

(54) **BESCHICHTETES WERKZEUG**
COATED TOOL
OUTIL REVÊTU

(30) Priorität: 02.07.2007 DE 102007030734
(43) Veröffentlichungstag der Anmeldung: 31.03.2010
(73) Patentinhaber: WALTER AG, 72072 Tübingen (DE)
(72) Erfinder: SCHIER, Veit, 70771 Echterdingen (DE)
(74) Vertreter: WSL Patentanwälte Partnerschaft mbB
(86) Internationale Anmeldenummer: PCT/EP2008/056038
(87) Internationale Veröffentlichungsnummer: WO 2009/003756

(56) Entgegenhaltungen:
- DE-A1- 19 937 284
- US-A- 5 447 804

## Beschreibung

Die Erfindung betrifft ein Schneidwerkzeug mit einem Grundkörper und einer darauf aufgebrachten ein- oder mehrlagigen Beschichtung.

### Stand der Technik

Schneidwerkzeuge bestehen aus einem Grundkörper, der beispielsweise aus Hartmetall, Cermet, Stahl oder Schnellarbeitsstahl hergestellt ist. Zu Erhöhung der Standzeiten oder auch zu Verbesserung der Schneideigenschaften wird auf den Grundkörper häufig eine ein- oder mehrlagige Beschichtung aufgebracht. Diese ein- oder mehrlagige Beschichtung umfasst beispielweise metallische Hartstoffschichten, Oxidschichten und dergleichen. Zum Aufbringen der Beschichtung werden CVD-Verfahren (chemische Gasphasenabscheidung; chemical vapour deposition) und/oder PVD-Verfahren (physikalische Gasphasenabscheidung; physical vapour deposition) angewendet. Mehre Lagen innerhalb einer Beschichtung können ausschließlich mittels CVD-Verfahren, ausschließlich mittels PVD-Verfahren oder durch einer Kombination dieser Verfahren aufgebracht werden. CVD-Verfahren liefern im wesentlichen stabile Phasen der gewünschten Verbindungen, wogegen sich mit PVD-Verfahren auch metastabile Phasen von Verbindungen aufbringen lassen.

Bei den PVD-Verfahren unterscheidet man zwischen verschiedenen Varianten, wie beispielsweise Magnetronsputtern, Lichtbogenverdampfen (Arc-PVD), Ionenplattierung, Elektronenstrahlverdampfung und Laserablation. Magnetronsputtern und Lichtbogenverdampfen zählen zu den am häufigsten für die Beschichtung von Werkzeugen angewendeten PVD-Verfahren. Von diesen PVD-Verfahrensvarianten gibt es wiederum unterschiedliche Abwandlungen bzw. Modifikationen, wie beispielweise ungepulstes oder gepulstes Magnetronsputtern oder ungepulstes oder gepulstes Lichtbogenverdampfen usw.

Aus der DE 10 2004 044 240 A1 ist ein Schneidwerkzeug mit einem Schichtaufbau mit wenigstens einer einphasigen, metastabilen zumindest ternären Oxidschicht bekannt, wobei die Oxidschicht neben Sauerstoff wenigstens zwei weitere chemische Elemente, ausgewählt unter den Elementen der IV., V. oder VI. Nebengruppe des Periodensystems, Aluminium und Silizium, enthält, von denen eines der Elemente eine Hauptkomponente und mindestens ein weiteres der Elemente mindestens eine Nebenkomponente bildet.

Die DE 199 37 284 A1 beschreibt einen elektrisch leitenden Mehrschichtaufbau auf einer metallischen Unterlage mit einer ersten Schicht aus einem sich durch natürlich gebildetes Oxid ober-flächlich passivierenden Metallmaterial, insbesondere Chrom, und einer mittels eines PVD-Verfahrens aus einem Gold- oder Goldlegierungsmaterial aufgebrachten weiten Schicht. Diese zweite Schicht ist in der Lage, die elektrisch isolierende Wirkung des natürlich gebildeten Oxidfilms der ersten Schicht wenigstens teilweise aufzuheben. Eingesetzt werden derartig beschichtete Anordnungen beispielsweise als Trägerteile zur geschirmten Aufnahme von Elektronikkomponenten.

Die DE 196 51 592 A1 beschreibt ein beschichtetes Schneidwerkzeug mit einer mehrlagigen Beschichtung, die wenigsten eine Aluminiumoxidlage und metallische Hartstofflagen umfasst. Die metallischen Hartstofflagen sind beispielsweise mittels PVD-Verfahren aufgebrachte TiAIN-Lagen. Auch die direkt darauf aufgebrachte Aluminiumoxidschicht ist im PVD-Verfahren abgeschieden.

Die DE 199 42 303 A1 beschreibt einen Schneideinsatz, der eine im CVD-Verfahren hergestellte mehrphasige Aluminiumoxidlage aufweist. Die im CVD-Verfahren hergestellte Schicht enthält Aluminiumoxid, Zirkonoxid sowie eine dritte feindisperse Phase aus einem Oxid, Oxycarbid, Oxynitrid oder Oxycarbonitrid von Titan.

Die DE 197 37 470 A1 beschreibt einen Schneidkörper mit einer Beschichtung, die wenigstens eine mehrphasige Lage aufweist. Die im CVD-Verfahren hergestellte Beschichtung umfasst beispielweise eine Zirkoncarbonnitridschicht (kubisches ZrCN) und ZrO₂ in monokliner und/oder tetragonaler Form. Die kristalline ZrCN-Matrix wirkt als harte Beschichtung, wogegen das darin eingelagerte ZrO₂ als Trockenschmierstoff wirkt.

Die DE 196 41 468 A1 beschreibt einen Verbundkörper, wie beispielsweise ein Schneidwerkzeug, der eine mehrlagige Beschichtung mit dünnen Aluminiumoxidschichten und/oder Zirkonoxidschichten aufweist.

Die US 5 447 804 beschreibt die Herstellung einer harten Schicht aus Al-Cr-Oxid-Mischkristall mit einem Chromanteil von wenigstens 5 At.-% durch Elektronenstrahlverdampfen, die mindestens so hart sein soll wie eine Hochtemperatur-CVD-Aluminiumoxidschicht.

Bei der Beschichtung von Schneidwerkzeugen, insbesondere im PVD-Verfahren, können aufgrund der normalerweise isolierenden Eigenschaften der abgeschiedenen Schichten nur relativ dünne Beschichtungen aufgebracht werden. Mit wachsender Schichtdicke wird der Abscheidungsprozeß der Ionen aus dem Plasma instabil, was sich z. B. besonders stark an den Ecken und Kanten des beschichteten Körpers zeigt und die Härte der Schichten nachteilig beeinflußt. Zur Herstellung eines Schneidwerkzeugs mit einer harten Beschichtung, die auch bei höheren Schichtdicken gute Eigenschaften aufweist, wäre daher eine Stabilisierung des Abscheidungsprozesses über einen längeren Zeitraum, d. h. auch bei höheren Schichtdicken, wünschenswert.

### Aufgabe

Die Aufgabe der vorliegenden Aufgabe bestand darin, gegenüber dem Stand der Technik verbesserte Schneidwerkzeuge bereitzustellen.

Gelöst wird die erfindungsgemäße Aufgabe durch ein Schneidwerkzeug mit einem Grundkörper, der vorzugsweise aus Hartmetall, Cermet, Stahl oder Schnellarbeitsstahl (HSS) hergestellt ist, und einer darauf aufgebrachten ein- oder mehrlagigen Beschichtung, dadurch gekennzeichnet, dass die Beschichtung wenigstens eine zwei- oder mehrphasige Lage umfasst, die wenigstens zwei verschiedene Phasen von Metalloxid enthält, wobei die wenigstens eine zwei- oder mehrphasige Lage elektrisch leitfähig ist und eine elektrische Leitfähigkeit von mehr als 1 S/m aufweist und wobei die wenigstens zwei verschiedenen Phasen von Metalloxid in der wenigstens einen zwei- oder mehrphasigen, elektrisch leitfähigen Lage wenigstens zwei verschiedene Phasen von Chromoxid sind.

Das Aufbringen einer ein- oder mehrlagigen Beschichtung auf ein Schneidwerkzeug als Verschleißschutzbeschichtung ist, wie oben bereits ausgeführt, seit langem bekannt. Neu ist hingegen die Herstellung einer solchen Beschichtung mit wenigstens einer zwei- oder mehrphasigen Lage, die elektrisch leitfähig ist und zwei verschiedene Phasen von Metalloxid enthält. Diese neuartige Beschichtung der vorliegenden Erfindung eröffnet ein breites Spektrum an Möglichkeiten zur Verbesserung und/oder Anpassung der Verschleißfestigkeit, der Standzeiten und/oder der Schneideigenschaften von Schneidwerkzeugen.

Die Verschleißbeständigkeit, Standfestigkeit und Schneideigenschaften einer Beschichtung auf einem Schneidwerkzeug hängt von verschiedenen Faktoren ab, wie beispielsweise dem Material des Grundkörpers des Schneidwerkzeugs, der Abfolge, Art und Zusammensetzung weiterer in der Beschichtung vorhandener Lagen, der Dicke der verschiedenen Lagen und nicht zuletzt der Art der mit dem Schneidwerkzeug durchgeführten Schneidoperation. Für ein und dasselbe Schneidwerkzeug können sich unterschiedliche Verschleißfestigkeiten in Abhängigkeit von der Art des zu bearbeitenden Werkstücks, dem jeweiligen Bearbeitungsverfahren und den weiteren Bedingungen während der Bearbeitung, wie beispielweise Entwicklung hoher Temperaturen oder Verwendung korrosiver Kühlflüssigkeiten, ergeben. Darüber hinaus unterscheidet man zwischen verschiedenen Verschleißarten, die je nach Bearbeitungsvorgang die Nutzungsdauer eines Werkzeugs, d. h. seine Standzeit, stärker oder geringer beeinflussen können. Die Weiterentwicklung und Verbesserung von Schneidwerkzeugen ist daher stets im Hinblick darauf zu betrachten, welche Werkzeugeigenschaften verbessert werden sollen, und unter vergleichbaren Bedingungen gegenüber dem Stand der Technik zu beurteilen.

Die wenigstens eine in der erfindungsgemäßen Beschichtung vorhandene zwei- oder mehrphasige, elektrisch leitfähige Lage mit wenigstens zwei verschieden Phasen von Metalloxid kann der gesamten Beschichtung des Schneidwerkzeugs Eigenschaften zu verleihen, die das Schneidwerkzeug gegenüber bekannten Schneidewerkzeugen bei vergleichbaren Schneidvorgängen und unter vergleichbaren Bedingungen überlegen machen. Diese Eigenschaften können die Verschleißfestigkeit, die Standzeiten, die Schneideigenschaften oder Kombinationen davon betreffen.

Erfindungsgemäß sind in der Beschichtung die wenigstens zwei verschiedenen Phasen von Metalloxid in der wenigstens einen zwei- oder mehrphasigen, elektrisch leitfähigen Lage wenigstens zwei verschiedene Phasen von Chromoxid. Die wenigstens eine zwei- oder mehrphasige Lage kann im wesentlich vollständig aus Chromoxid bestehen. Bevorzugt enthält sie Chromoxid zumindest als Hauptkomponente, d. h. in einer gegenüber möglichen weiteren Komponenten überwiegenden Menge mit einem Anteil von Chrom gegenüber anderen metallischen Elementen von wenigstens 80 Atom-%, vorzugsweise wenigstens 90 Atom-%, besonders bevorzugt wenigstens 95 Atom-%. Als Nebenkomponente kann die wenigstens zwei- oder mehrphasige Lage Carbide, Nitride, Oxide, Carbonitride, Oxinitride, Oxicarbide, Oxicarbonitride, Boride, Boronitride und Oxoboronitride der Elemente der Gruppen IVa bis Vlla des Periodensystems und/oder des Aluminiums und/oder von Silizium, gemischtmetallische Phasen sowie Phasengemische der vorgenannten Verbindungen enthalten, wobei Chrom als Element der Nebenkomponente ausgenommen ist.

Hauptkomponente im Sinne der vorliegenden Erfindung bedeutet, dass das metallische Element gegenüber anderen metallischen Elementen der gleichen Lage in einer Menge von wenigstens 80 Atom-%, vorzugsweise wenigstens 90 Atom-%, besonders bevorzugt wenigstens 95 Atom% vorliegt. Die Verbindungen der anderen Metalle in der gleichen Lage werden als Nebenkomponente im Sinne der vorliegenden Erfindung bezeichnet.

In einer weiteren Ausführungsform weist die wenigstes eine zwei- oder mehrphasige Lage wenigstens drei Phasen auf, wobei wenigstes eine Phase von Aluminiumoxid vorliegt. Bei dieser Ausführungsform kann das andere Metalloxid, welches nicht Aluminiumoxid ist und von welchem wenigstens zwei verschiedene Phasen in der Lage vorliegen, als Hauptkomponente und Aluminiumoxid als Nebenkomponente vorliegen. In einer bevorzugten Variante dieser Ausführungsform enthält die zwei- oder mehrphasige Lage wenigstens zwei Phasen von Chromoxid als Hauptkomponente und eine Phase von Aluminiumoxid als Nebenkomponente oder Mischphasen von Chromoxid und Aluminiumoxid.

In einer weiteren Ausführungsform der Erfindung ist eine der Metalloxidphasen in der zwei- oder mehrphasigen Lage eine stabile Phase von Metalloxid. In der erfindungsgemäßen Ausführungsform, in der die wenigstens eine zwei- oder mehrphasige Lage Chromoxid als Hauptkomponente enthält, ist die stabile Phase von Metalloxid vorzugsweise eine Phase von Cr₂O₃.

In einer weiteren Ausführungsform der Erfindung ist wenigstens eine der Metalloxidphasen in der zwei- oder mehrphasigen Lage eine metastabile Phase. In der Ausführungsform, in der die wenigstens eine zwei- oder mehrphasige Lage Chromoxid als Hauptkomponente enthält, ist die metastabile Phase vorzugsweise eine metastabile Phase von Chromoxid der Stöchiometrie CrOₓ mit 0,7 ≤ x ≤ 1,3.

Der Begriff "stabile Phase" im Sinne dieser Erfindung bedeutet, eine Phase, die sich unter den gegebenen Bedingungen in einem thermodynamisch stabilen Gleichgewichtszustand befindet und sich nicht verändert.

Der Begriff "metastabile Phase" im Sinne dieser Erfindung bedeutet, eine Phase, die sich nur scheinbar in einem thermodynamischen Gleichgewichtszustand befindet, weil unter den gegebenen Bedingungen, wie z. B. Druck und/oder Temperatur, die Einstellungsgeschwindigkeit des Gleichgewichts, d.h. der Übergang in den thermodynamisch stabilen, energieärmeren Zustand zu gering ist. Metastabile Phasen bzw. Zustände sind solche Phasen bzw. Zustände, die nur durch Beseitigung einer Hemmung in stabile Phasen bzw. Zustände übergehen. Die Beseitigung der Hemmung kann durch Energieeintrag erfolgen, wie z. B. Erhöhung der Temperatur oder des Drucks.

In einer bevorzugten Ausführungsform der Erfindung, bei der die wenigsten zwei verschiedenen Phasen von Metalloxid in der zwei- oder mehrphasigen Lage Chromoxidphasen sind, weisen die Elemente Chrom und Sauerstoff in den stabilen und metastabilen Phasen zusammengenommen ein Verhältnis von Cr zu O von etwa 1 zu 0,8 - 1,2 auf. Ist das Verhältnis von Cr zu O größer als 1 zu 0,8 (d.h. 1 zu <0,8), so hat dies den Nachteil, daß die Lage zu weich wird. Ist das Verhältnis von Cr zu O kleiner als 1 zu 1,2 (d.h. 1 zu >1,2), so hat dies den Nachteil daß die Lage zu spröde wird.

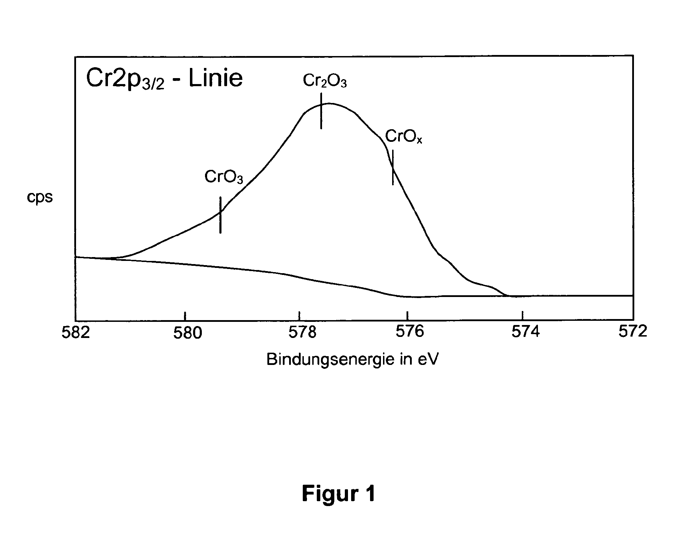

In einer weiteren bevorzugten Ausführungsform der Erfindung ist unter den wenigstens zwei verschiedenen Phasen von Metalloxid in der wenigstens einen zwei- oder mehrphasigen Lage wenigstens eine Metalloxidphase elektrisch leitfähig. Besteht die Hauptkomponente der zwei-oder mehrphasigen Lage aus Chromoxid, so ist keine Phase von CrO₂, die für sich gesehen eine leitfähige Chromoxidphase darstellen würde, enthalten. Nachweisbar ist das Fehlen einer Phase von CrO₂ in der elektrisch leitfähigen Lage mittels XPS-Messung. In einer solchen Chromoxid als Hauptkomponente enthaltenden Lage wurden mittels XPS-Messungen Phasen von Cr₂O₃, CrO₃, CrOₓ mit 0,7 ≤ x ≤ 1,3, jedoch keine Phase von CrO₂ nachgewiesen (vgl. Figur 1). Die elektrische Leitfähigkeit der zwei- oder mehrphasigen Lage beruht somit nicht auf dem Vorhandensein von an sich elektrisch leitfähigem CrO₂.

Die wenigstens eine zwei- oder mehrphasige Lage der Beschichtung hat bevorzugt eine Schichtdicke von 10 nm bis 50 µm. Ist die Schichtdicke der zwei- oder mehrphasigen Lage geringer als 10 nm, so ist ihre Schutz- bzw. Verschleißschutzfunktion zu gering. Ist die Schichtdicke der zwei- oder mehrphasigen Lage größer als 50 µm, so entstehen in der Lage zu hohe Spannungen und die Lage wird zu spröde, was zu Haftungsproblemen und Abplatzern beim Betrieb des Werkzeugsführen führen kann. In einer weiteren Ausführungsform weist die Lage eine Schichtdicke von 20 nm bis 20 µm auf. In noch einer weiteren Ausführungsform weist die Lage eine Schichtdicke von 0,5 µm bis 4 µm auf.

Üblicherweise hat die wenigstens eine zwei- oder mehrphasige Lage eine Vickers-Härte (Hv) von 500 bis 4000. In einer bevorzugten Ausführungsform weist die Lage eine Vickers-Härte (Hv) von 700 bis 3000 auf. In noch einer weiteren bevorzugten Ausführungsform weist die Lage eine Vickers-Härte (Hv) von 800 bis 2000 auf.

Die elektrische Leitfähigkeit der wenigstens einen zwei- oder mehrphasigen Lage in der Beschichtung der vorliegenden Erfindung ist deutlich höher als diejenige von Nichtleitern und Halbleitern und liegt in der Größenordnung von metallischen Leitern. Sie beträgt erfindungsgemäß mehr als 1 S/m. Bevorzugt beträgt die elektrische Leitfähigkeit mehr als 100 S/m. In einer weiteren Ausführungsform weist die Lage eine elektrische Leitfähigkeit von mehr als 10⁴ S/m auf.

Die elektrische Leitfähigkeit der in der erfindungsgemäßen Beschichtung enthaltenden zwei-oder mehrphasigen Lage ist ein überraschendes Phänomen, da die Lage als Hauptkomponente Metalloxide enthält, die üblicherweise nicht leitend sind. Die Leitfähigkeit der Lage ist auch nicht auf das Vorhandensein von Phasen reiner Metalle zurückzuführen, da diese in der Lage gar nicht oder nur in vernachlässigbar geringen Mengen, die eine elektrische Leitfähigkeit der gesamten Lage nicht begründen können, vorhanden sind. Die zwei- oder mehrphasige Lage in der Beschichtung der Erfindung enthält auch keine Phasen von Metalloxiden, die für sich gesehen als elektrisch leitfähig bekannt sind, wie beispielsweise, CrO₂, in Anteilen, die eine elektrische Leitfähigkeit der gesamten Lage begründen könnten.

Eine eindeutige Erklärung für die elektrische Leitfähigkeit der erfindungsgemäßen zwei- oder mehrphasigen Lagen in der Beschichtung kann zur Zeit nicht angegeben werden. Es wird jedoch angenommen, dass die erfindungsgemäße zwei- oder mehrphasige Lage metastabile, nicht-stöchiometrische Metalloxidphasen enthält, die der gesamten Lage elektrische Leitfähigkeit in der Größenordung der Leitfähigkeit von Metallen verleiht und zu den hervorragenden Materialeigenschaften der erfindungsgemäßen Beschichtung beitragen.

In einer weitern Ausführungsform der Erfindung weist die wenigstens eine zwei- oder mehrphasigen Lage weiterhin wenigstes eine Nebenkomponente auf. Als Nebenkomponente(n) kann die wenigstens zwei- oder mehrphasige Lage Carbide, Nitride, Oxide, Carbonitride, Oxinitride, Oxicarbide, Oxicarbonitride, Boride, Boronitride und Oxoboronitride der Elemente der Gruppen IVa bis Vlla des Periodensystems und/oder des Aluminiums und/oder von Silizium, gemischtmetallische Phasen sowie Phasengemische der vorgenannten Verbindungen enthalten. Beispiele für solche Nebenkomponenten sind (Al, Cr)₂O₃ mit einem Gewichts-Verhältnis Al:Cr = 9:1, (Cr, Al, Si)₂O₃ mit einem Gewichts-Verhältnis Al:Si = 9:1 und Cr:(Al, Si) = 1:2.

Ist die Beschichtung des erfindungsgemäßen Schneidwerkzeugs mehrlagig, so kann sie weitere Hartstofflagen mit den oben für die Nebenkomponenten angegebenen Zusammensetzungen umfassen. Beispiele für solche Hartstofflagen sind Lagen aus Al₂O₃, TiN, TiB₂, cBN, hBN, TiBN, TiC, TiCN, TiN, TiAIN, CrAIN, TiAICN, TiAIYN, TiAICrN und CrN. Anstelle oder zusätzlich zu einer oder mehreren Hartstofflagen kann die Beschichtung eine oder mehrere weitere zwei-oder mehrphasige Lagen aufweisen, die wenigstens zwei verschiedene Phasen von Metalloxid enthalten und elektrisch leitfähig sind. Die vorliegende Erfindung umfaßt somit Beschichtungen, die nur aus einer oder mehreren der zwei- oder mehrphasigen Lagen mit wenigstens zwei verschiedenen Phasen von Metalloxid elektrischer Leitfähigkeit bestehen, sowie auch Beschichtungen, die jede Kombination aus solchen Lagen mit weiteren Hartstofflagen in beliebiger Anzahl und Abfolge umfassen.

Bevorzugte Beschichtungen des erfindungsgemäßen Schneidwerkzeugs weisen folgende Lagen auf:
(Al, Cr)₂O₃ - AICrN - (Al, Cr)O,
TiAIN - (Al, Cr)O,
AICrN - (Al, Cr)O,
TiAIN - Al₂O₃ - (Al, Cr)O,
CrAIN - [(Al, Cr)O - Al₂O₃]ₓ - ZrN

Die in der Beschichtung des erfindungsgemäßen Schneidwerkzeugs enthaltene zwei- oder mehrphasige Lage mit wenigstens zwei verschiedenen Phasen von Metalloxid und elektrischer Leitfähigkeit wird vorzugsweise im PVD-Verfahren, besonders bevorzugt durch Magnetronsputtern, Lichtbogenverdampfen auf (Arc-PVD) oder Modifikationen dieser Verfahren erzeugt. In der PVD-Beschichtungsanlage wird eine Plasmaatmosphäre mit niedrigem Druck erzeugt, die im wesentlichen aus Argon und Sauerstoff besteht. Im PVD-Magnetronverfahren wird vor dem Target ein Argonplasma gezündet. Es kommt zur Hochleistungskathodenzerstäubung (Magnetronsputtern). Der so von dem Target erzeugte Metalldampf scheidet sich unter Reaktion mit dem Sauerstoff als Metalloxidschicht auf dem Substrat ab.

Weitere Vorteile, Merkmale und Ausführungsformen der vorliegenden Erfindung werden anhand der nachfolgenden Beispiele und der Figur erläutert.

### Beispiel 1

In einer PVD-Beschichtungsanlage (Flexicoat; Hauzer Techno Coating) wurden Hartmetallsubstrate mit einer zweilagigen PVD-Beschichtung versehen. Vor der Abscheidung der Lagen wurde die Anlage auf 1x10⁻⁵ mbar evakuiert und die Hartmetalloberfläche durch lonenätzen mit 170 V Vorspannung gereinigt.

| Substratzusammensetzungen: | 1) HM-Feinkorn + 10,5 Gew.-% Co |
|---|---|
| | 2) HM-Grobkorn + 10,5 Gew.-% Co + 1 Gew.-% MC |
| | 3) HM-Grobkorn + 11,0 Gew.-% Co + 1 Gew.-% MC |
| (Erläuterung: | HM-Feinkorn = WC-Hartmetall mit mittlerer Korngröße von - 1µm |
| | HM-Grobkorn = WC-Hartmetall mit mittlerer Korngröße von 3 - 5 µm) |
| | MC = Mischcarbide (TiC, TaC ...) |
| | |
| Substratgeometrie: | SEHW120408 (nach DIN-ISO 1832) |

### Abscheidung der Lagen:

### 1. Lage: TiAIN

■ Lichtbogenabscheidung,
■ Target: Ti/Al (33/67 At.-%) Rundquelle (63 mm Durchmesser),
■ 80 Ampere, 495°C, 3 Pa N₂-Druck, 40 Volt Substratvorspannung,
■ 3µm Schichtdicke;

### 2. Lage: (Al,Cr)₂O₃

■ Reaktives Magnetronsputtern,
■ Target: Al/Cr (90/10 At.-%) Rundquelle (63 mm Durchmesser),
■ 10 kW Sputterleistung, 495°C, 0,5 Pa Ar-Druck, ca. 100 sccm O₂, 150 Volt Substratvorspannung (unipolar gepulst),
■ 1 µm Schichtdicke.

Die TiAIN-Lage dient der Haftungsvermittlung zwischen dem Substrat und der oxidischen Lage. An der Beschichtung wurden XRD-Messungen, XPS-Messungen, Mikrosondenmessungen und Widerstandsmessungen durchgeführt. Die Mikrosondenmessungen zur Bestimmung der Gesamtzusammensetzung wurden an einer einzelnen (Al, Cr)₂O₃-Lage durchgeführt, da Messungen am Lagenverbund TiAIN-(Al, Cr)₂O₃ mit der Mikrosonde zu Meßfehlern führt. Widerstands- bzw. Leitfähigkeitsmessungen ergaben, daß die (Al, Cr)₂O₃-Lage bei allen Substraten insgesamt elektrisch leitfähig war mit Leitfähigkeiten von etwa 10 S/m.

Durch XRD- und XPS-Messung wurde festgestellt, daß die (Al, Cr)₂O₃-Lage bei allen Substraten eine stabile y-Al₂O₃-Phase, zwei stabile Cr-Oxid-Phasen (crO₃, Cr₂O₃) und eine metastabile Cr-Oxid-Phase (CrOₓ) enthielt. Figur 1 zeigt das XPS-Spektrum von Cr (Mg Kα-Strahlung). Die XPS-Messung bestätigte, daß die Lage insgesamt 3 Chromoxidphasen enthielt. Die aus der XPS-Messung abgeschätzten Phasenanteile waren ungefähr wie folgt:

| | |
|---|---|
| Cr₂O₃ | 65 Gew.% |
| CrOₓ | 20 Gew.-% |
| CrO₃ | 15 Gew.-%, |

wobei x = 0,9 betrug. Des weiteren ergaben die Ergebnisse der Messungen, daß innerhalb der (Al, Cr)₂O₃-Lage die metastabile Cr-Oxid-Phase die einzige der Metalloxidphasen war, die elektrisch leitfähig war und der Gesamtlage die Leitfähigkeit verlieh. Eine Phase von leitfähigem CrO₂ konnte aufgrund der ermittelten Phasenanteile und des durch Mikrosondenmessung bestimmten Sauerstoffanteils ausgeschlossen werden.

### Vergleichsbeispiel

Zum Vergleich wurden auf die gleichen Substrate wie in Beispiel 1 in der gleichen Beschichtungsanlage mit einer zweilagigen Beschichtung der Lagenfolge 3 µm TiAIN - 1 µm Al₂O₃ versehen. Die Abscheidungsbedingungen waren die gleichen wie in Beispiel 1 mit der Ausnahme, daß in Stufe für die Abscheidung der Al₂O₃-Lage ein reines Al-Target verwendet wurde.

In einem Fräsversuch an einem Werkstück aus 42CrMoV4-Stahl (Festigkeit: 850 MPa) wurden die Werkzeuge aus Beispiel 1 und dem Vergleichsbeispiel verglichen. Es wurde im Gleichlauf ohne Kühlschmierstoff mit einer Schnittgeschwindigkeit v_{c} = 236 m/min und einem Zahnvorschub f_{z} = 0,2 mm gefräst.

Der Verschleiß wurde auf der Freifläche als mittlere Verschleißmarkenbreite VB in mm (an der Hauptschneide) nach einem Fräsweg von 4800 mm gemessen. Es wurden folgende Verschleißmarkenbreiten VB festgestellt:

| | Verschleißmarkenbreite VB |
|---|---|
| **Beispiel 1:** | 0,09 mm |
| **Vergleichsbeispiel:** | 0,12 mm |

## Patentansprüche

1. Schneidwerkzeug (1) mit einem Grundkörper (2), der vorzugsweise aus Hartmetall, Cermet, Stahl oder Schnellarbeitsstahl (HSS) hergestellt ist, und einer darauf aufgebrachten ein- oder mehrlagigen Beschichtung (3), **dadurch gekennzeichnet, dass** die Beschichtung wenigstens eine zwei- oder mehrphasige Lage (4) umfasst, die wenigstens zwei verschiedene Phasen von Metalloxid enthält, wobei die wenigstens eine zwei- oder mehrphasige Lage (4) elektrisch leitfähig ist und eine elektrische Leitfähigkeit von mehr als 1 S/m aufweist und wobei die wenigstens zwei verschiedenen Phasen von Metalloxid in der wenigstens einen zwei- oder mehrphasigen, elektrisch leitfähigen Lage (4) wenigstens zwei verschiedene Phasen von Chromoxid sind.

2. Schneidwerkzeug nach Anspruch 1, **dadurch gekennzeichnet, dass** die wenigstens eine zwei- oder mehrphasige Lage (4) Chromoxid als Hauptkomponente enthält.

3. Schneidwerkzeug nach einem der Ansprüche 1 oder 2, **dadurch gekennzeichnet, dass** die wenigstens eine zwei- oder mehrphasige Lage (4) wenigstens drei Phasen aufweist, wobei wenigstens eine Phase von Aluminiumoxid vorliegt.

4. Schneidwerkzeug nach einem der Ansprüche 1 bis 3, **dadurch gekennzeichnet, dass** eine der Metalloxidphasen in der zwei- oder mehrphasigen Lage (4) eine stabile Phase von Metalloxid ist, vorzugsweise eine Phase von Cr₂O₃.

5. Schneidwerkzeug nach einem der Ansprüche 1 bis 4, **dadurch gekennzeichnet, dass** wenigstens eine der Matalloxidphasen in der zwei- oder mehrphasigen Lage (4) eine metastabile Phase ist, vorzugsweise eine metastabile Phase von Chromoxid der Stöchiometrie CrOₓ mit 0,7 ≤ x ≤ 1,3.

6. Schneidwerkzeug nach einem der Ansprüche 1 bis 5, **dadurch gekennzeichnet, dass** die wenigstens zwei verschiedenen Phasen von Metalloxid in der zwei- oder mehrphasigen Lage (4) Chromoxidphasen sind, die zusammengenommen ein Verhältnis der Elemente Cr zu O von etwa 1 zu 0,8 - 1,2 aufweisen.

7. Schneidwerkzeug nach einem der Ansprüche 1 bis 6, **dadurch gekennzeichnet, dass** unter den wenigstens zwei verschiedenen Phasen von Metalloxid in der wenigstens einen zwei- oder mehrphasigen Lage (4) wenigstens eine Metalloxidphase elektrisch leitfähig ist.

8. Schneidwerkzeug nach einem der Ansprüche 1 bis 7, **dadurch gekennzeichnet, dass** die Metalloxidphasen in der zwei- oder mehrphasigen Lage (4) nicht eine Phase von CrO₂ umfassen.

9. Schneidwerkzeug nach einem der Ansprüche 1 bis 8, **dadurch gekennzeichnet, dass** die wenigstens eine zwei- oder mehrphasige Lage (4) eine Schichtdicke von 10 nm bis 50 µm, vorzugsweise von 20 nm bis 20 µm, besonders bevorzugt von 0,5 µm bis 4 µm aufweist.

10. Schneidwerkzeug nach einem der Ansprüche 1 bis 9, **dadurch gekennzeichnet, dass** die wenigstens eine zwei- oder mehrphasige Lage (4) eine Vickers-Härte (Hv) von 500 bis 4000, vorzugsweise von 700 bis 3000, besonders bevorzugt von 800 bis 2000 aufweist.

11. Schneidwerkzeug nach einem der Ansprüche 1 bis 10, **dadurch gekennzeichnet, dass** die wenigstens eine zwei- oder mehrphasige Lage (4) eine elektrische Leitfähigkeit von mehr als 100 S/m, besonders bevorzugt mehr als 10⁴ S/m aufweist.

12. Schneidwerkzeug nach einem der Ansprüche 1 bis 11, **dadurch gekennzeichnet, dass** die wenigstens eine zwei- oder mehrphasige Lage (4) weiterhin wenigstens eine Nebenkomponente aufweist, die von Elementen der IV., V. oder VI. Nebengruppe des periodischen Systems der Elemente, Aluminium und/oder Silizium und von O, N, C und/oder B gebildet wird, und/oder dass die Beschichtung (3) weitere Hartstofflagen umfasst, die von Elementen der IV., V. oder VI. Nebengruppe des periodischen Systems der Elemente, von Aluminium und/oder von Silizium und von O, N, C und/oder B gebildet werden.

13. Schneidwerkzeug nach einem der Ansprüche 1 bis 12, **dadurch gekennzeichnet, dass** die wenigstens eine zwei- oder mehrphasige Lage (4) im PVD-Verfahren, vorzugsweise durch Magnetronsputtern, Lichtbogenverdampfen (Arc-PVD) oder Modifikationen dieser Verfahren erzeugt wird.

14. Schneidwerkzeug nach einem der Ansprüche 1 bis 13, **dadurch gekennzeichnet, dass** die Beschichtung wenigstens zwei der zwei- oder mehrphasigen Lagen (4, 4') gemäß einem der vorangegangenen Ansprüche umfasst, wobei die wenigstens zwei der zwei- oder mehrphasigen Lagen (4, 4') unmittelbar übereinander angeordnet sind oder durch eine oder mehrere weitere Hartstofflagen voneinander getrennt sind, wobei vorzugsweise die wenigstens zwei der zwei- oder mehrphasigen Lagen (4, 4') unterschiedliche Zusammensetzungen, unterschiedliche Vickers-Härten (Hv) und/oder unterschiedliche Leitfähigkeiten aufweisen.

## Claims

1. Cutting tool (1) having a base body (2), which is preferably made of hard metal, cermet, steel or high-speed steel (HSS), and a single- or multi-layer coating (3) applied thereto, **characterized in that** the coating includes at least one two-phase or multi-phase layer (4), which contains at least two different phases of metal oxide, wherein the at least one two-phase or multi-phase layer (4) is electrically conductive and is of an electrical conductivity of more than 1 S/m and wherein the at least two different phases of metal oxide in the at least one two-phase or multi-phase electrically conductive layer (4) are at least two different phases of chromium oxide.

2. Cutting tool according to claim 1, **characterized in that** the at least one two-phase or multi-phase layer (4) contains chromium oxide as the main component.

3. Cutting tool according to one of claims 1 or 2, **characterized in that** the at least one two-phase or multi-phase layer (4) has at least three phases, wherein there is at least one phase of aluminium oxide.

4. Cutting tool according to one of claims 1 to 3, **characterized in that** one of the metal oxide phases in the two-phase or multi-phase layer (4) is a stable phase of metal oxide, preferably a phase of Cr₂O₃.

5. Cutting tool according to one of claims 1 to 4, **characterized in that** at least one of the metal oxide phases in the two-phase or multi-phase layer (4) is a metastable phase, preferably a metastable phase of chromium oxide of the stoichiometry CrOₓ, with 0.7 ≤ x ≤ 1.3.

6. Cutting tool according to one of claims 1 to 5, **characterized in that** the at least two different phases of metal oxide in the two-phase or multi-phase layer (4) are chromium oxide phases which taken together have a ratio of the elements Cr to O of about 1 to 0.8 - 1.2.

7. Cutting tool according to one of claims 1 to 6, **characterized in that** among the at least two different phases of metal oxide in the at least one two-phase or multi-phase layer (4) at least one metal oxide phase is electrically conductive.

8. Cutting tool according to one of claims 1 to 7, **characterized in that** the metal oxide phases in the two-phase or multi-phase layer (4) do not include a phase of CrO₂.

9. Cutting tool according to one of claims 1 to 8, **characterized in that** the at least one two-phase or multi-phase layer (4) is of a layer thickness of 10 nm to 50 µm, preferably 20 nm to 20 µm, particularly preferably 0.5 µm to 4 µm.

10. Cutting tool according to one of claims 1 to 9, **characterized in that** the at least one two-phase or multi-phase layer (4) is of a Vickers hardness (Hv) of 500 to 4000, preferably 700 to 3000, particularly preferably 800 to 2000.

11. Cutting tool according to one of claims 1 to 10, **characterized in that** the at least one two-phase or multi-phase layer (4) is of an electrical conductivity of more than 100 S/m, particularly preferably more than 10⁴ S/m.

12. Cutting tool according to one of claims 1 to 11, **characterized in that** the at least one two-phase or multi-phase layer (4) further has at least one secondary component formed by elements of subgroups IV, V or VI of the periodic system of the elements, aluminium and/or silicon and O, N, C and/or B and/or that the coating (3) includes further hard material layers formed by elements of subgroups IV, V or VI of the periodic system of the elements, aluminium and/or silicon and O, N, C and/or B.

13. Cutting tool according to one of claims 1 to 12, **characterized in that** the at least one two-phase or multi-phase layer (4) is produced by a PVD process, preferably by magnetron sputtering, arc vapor deposition (arc PVD) or modifications of said processes.

14. Cutting tool according to one of claims 1 to 13, **characterized in that** the coating includes at least two of the two-phase or multi-phase layers (4, 4') according to one of the preceding claims, wherein the at least two of the two-phase or multi-phase layers (4, 4') are arranged in directly superposed relationship or are separated from each other by one or more further hard material layers, wherein preferably the at least two of the two-phase or multi-phase layers (4, 4') are or different compositions, different Vickers hardness (Hv) and/or different conductivities.

## Revendications

1. Outil de coupe (1) avec un corps de base (2) qui est fabriqué de préférence en métal dur, en cermet, en acier ou en acier rapide (HSS) et avec un revêtement monocouche ou multicouche (3) appliqué dessus, **caractérisé en ce que** le revêtement comprend au moins une couche à deux ou plusieurs phases (4) qui contient au moins deux phases différentes d'oxyde métallique, l'au moins une couche à deux ou plusieurs phases (4) étant électriquement conductrice et ayant une conductivité électrique de plus de 1 S/m et les au moins deux phases différentes d'oxyde métallique dans l'au moins une couche à deux ou plusieurs phases (4) électriquement conductrice étant au moins deux phases différentes d'oxyde de chrome.

2. Outil de coupe selon la revendication 1, **caractérisé en ce que** l'au moins une couche à deux ou plusieurs phases (4) contient de l'oxyde de chrome comme composant principal.

3. Outil de coupe selon l'une des revendications 1 ou 2, **caractérisé en ce que** l'au moins une couche à deux ou plusieurs phases (4) comporte au moins trois phases, au moins une phase d'oxyde d'aluminium étant présente.

4. Outil de coupe selon l'une des revendications 1 à 3, **caractérisé en ce que** l'une des phases d'oxyde métallique dans la couche à deux ou plusieurs phases (4) est une phase stable d'oxyde métallique, de préférence une phase de CR₂O₃.

5. Outil de coupe selon l'une des revendications 1 à 4, **caractérisé en ce qu'**au moins l'une des phases d'oxyde métallique dans la couche à deux ou plusieurs phases (4) est une phase métastable, de préférence une phase métastable d'oxyde de chrome de stoechiométrie CrOₓ avec 0,7 ≤ x ≤ 1,3.

6. Outil de coupe selon l'une des revendications 1 à 5, **caractérisé en ce que** les au moins deux phases différentes d'oxyde métallique dans la couche à deux ou plusieurs phases (4) sont des phases d'oxyde de chrome qui présentent, prises ensemble, un rapport des éléments Cr à O d'environ 1 à 0,8 - 1,2.

7. Outil de coupe selon l'une des revendications 1 à 6, **caractérisé en ce que**, parmi les au moins deux phases différentes d'oxyde métallique dans l'au moins une couche à deux ou plusieurs phases (4), au moins une phase d'oxyde métallique est électriquement conductrice.

8. Outil de coupe selon l'une des revendications 1 à 7, **caractérisé en ce que** les phases d'oxyde métallique dans la couche à deux ou plusieurs phases (4) ne comprennent pas de phase de CrO₂.

9. Outil de coupe selon l'une des revendications 1 à 8, **caractérisé en ce que** l'au moins une couche à deux ou plusieurs phases (4) a une épaisseur de couche comprise entre 10 nm et 50 µm, de préférence entre 20 nm et 20 µm, notamment de manière préférée entre 0,5 µm et 4 µm.

10. Outil de coupe selon l'une des revendications 1 à 9, **caractérisé en ce que** l'au moins une couche à deux ou plusieurs phases (4) a une dureté Vickers (Hv) comprise entre 500 et 4000, de préférence entre 700 et 3000, notamment de manière préférée entre 800 et 2 000.

11. Outil de coupe selon l'une des revendications 1 à 10, **caractérisé en ce que** l'au moins une couche à deux ou plusieurs phases (4) présente une conductivité électrique de plus de 100 S/m, notamment de manière préférée de plus de 10⁴ S/m.

12. Outil de coupe selon l'une des revendications 1 à 11, **caractérisé en ce que** l'au moins une couche à deux ou plusieurs phases (4) comporte en outre au moins un composant secondaire qui est formé d'éléments du groupe secondaire IV, V ou VI du système périodique des éléments, d'aluminium et/ou de silicium et de O, N, C et/ou B et/ou **en ce que** le revêtement (3) comprend d'autres couches de matériau dur qui sont formées d'éléments du groupe secondaire IV, V ou VI du système périodique des éléments, d'aluminium et/ou de silicium et de O, N, C et/ou B.

13. Outil de coupe selon l'une des revendications 1 à 12, **caractérisé en ce que** l'au moins une couche à deux ou plusieurs phases (4) est produite par un procédé de dépôt en phase vapeur, de préférence une pulvérisation par magnétron, une vaporisation par arc électrique (Arc-PVD) ou des variantes de ces procédés.

14. Outil de coupe selon l'une des revendications 1 à 13, **caractérisé en ce que** le revêtement comprend au moins deux couches à deux ou plusieurs phases (4, 4') selon l'une des revendications précédentes, les au moins deux couches à deux ou plusieurs phases (4, 4') étant agencées directement les unes au-dessus des autres ou étant séparées les unes des autres par une ou plusieurs autres couches de matériau dur, les au moins deux couches à deux ou plusieurs phases (4, 4') ayant de préférence des compositions différentes, des duretés Vickers (Hv) différentes et/ou des conductivités différentes.
